# DEMANDE DE BREVET EUROPEEN

(11) **EP 4 765 002 A1**
(43) Date de publication de la demande: **24.06.2026**
(21) Numéro de dépôt: 25223442.2
(22) Date de dépôt: 15.12.2025
(51) Int. Cl.: G06Q 50/06, H02J 3/00, H02J 13/00, G06N 3/045, G06N 3/08

(54) **PROCEDE ET SYSTEME DE DESAGREGATION DE CHARGES**

(30) Priorité: 18.12.2024 FR 2414476
(71) Demandeur: SAGEMCOM ENERGY & TELECOM SAS, 92270 Bois-Colombes (FR)
(72) Inventeur: MAALEJ, Asma, 92270 BOIS-COLOMBES (FR); HLEL, El Kefi, 92270 BOIS-COLOMBES (FR); RAZAZIAN, Kaveh, 92270 BOIS-COLOMBES (FR)
(74) Mandataire: Cabinet Le Guen Maillet

(57) **Abrégé**

Procédé de désagrégation de charges qui comporte une phase opérationnelle comprenant, dans chaque branche de calcul i (B-i) parmi M branches de calcul exécutées en parallèle et configurées chacune pour un type i d'appareil électrique parmi M types, avec M ≥ 2 et 0 < i ≤ M, effectuer : une première classification (401-i) permettant de décider si un appareil électrique du type i est présent sur le réseau électrique du foyer ; en cas de décision de présence d'un appareil électrique du type i, effectuer une deuxième classification permettant de générer une valeur estimée d'un état de fonctionnement de l'appareil électrique du type i, puis une estimation de consommation de puissance individuelle de l'appareil électrique du type i. Puis concaténer (404), dans un vecteur de sortie, M valeurs estimées de consommation de puissance individuelle associées aux M branches de calcul.

## Description

### DOMAINE TECHNIQUE

La présente invention concerne un procédé et un système de désagrégation de charges.

La désagrégation de charges (aussi appelée « décomposition de charges ») consiste à décomposer la consommation de puissance (aussi appelée « charge ») d'un foyer en détectant les appareils électriques (comme les panneaux solaires, les chargeurs de voitures électriques, les appareils électroménagers, etc.) présents derrière le compteur d'électricité du foyer (c'est-à-dire présents sur le réseau électrique du foyer connecté à ce compteur d'électricité) et en déterminant (estimant) la consommation de puissance individuelle de chacun des appareils électriques détectés.

### ETAT DE LA TECHNIQUE ANTERIEURE

L'information apportée par la désagrégation de charges est primordiale aussi bien pour les fournisseurs d'électricité que pour les clients (utilisateurs), car cette information peut être utilisée pour déclencher différentes actions visant à agir sur une consommation de puissance future d'au moins un des appareils électriques du foyer et/ou sur une charge globale future, planifiée et gérée par les fournisseurs d'électricité.

Par exemple, la connaissance de l'information apportée par la désagrégation de charges de différents foyers permet à un fournisseur d'électricité :
- en appliquant des outils d'analyse de données, de prédire (estimer) la charge globale de son réseau électrique (par exemple au niveau national) et d'élaborer une stratégie de délestage et de transfert de charge (pour aplatir la courbe de charge et éviter un dépassement de la limite de production) lorsque la consommation d'énergie prédite dépasse cette limite de production ;
- de taxer différemment les appareils électriques d'un même foyer. Par exemple, quand un chargeur de véhicule électrique est détecté, sa consommation de puissance est facturée différemment des autres appareils électriques du foyer, sans avoir recours à un compteur d'électricité additionnel pour ce foyer ;
- de changer l'attitude de consommation de puissance des utilisateurs en les incitant par exemple à éviter les utilisations de quelques appareils électriques non indispensables s'il y a dépassement de la limite de production. Ce changement de la consommation de charge peut être fait par les fournisseurs d'électricité par la surtaxation de la consommation de puissance des appareils non indispensables ce qui permettra à faire un déplacement de la charge à l'échelle nationale et avoir une courbe de charge plus plate. Par exemple, les fournisseurs peuvent surtaxer l'utilisation d'une machine à laver à midi pendant un jour de canicule et considérer un prix normal de la puissance consommée par un réfrigérateur ;
- dans les cas extrêmes, de faire un délestage des foyers ne répondant pas à l'appel de réduction de charge pendant les heures de grande affluence. Le fournisseur d'électricité peut aussi un délestage sélectif au sein du foyer, portant uniquement sur les appareils électriques détectés comme énergivores, si la fonctionnalité d'activation et désactivation à distance des appareils électriques est disponible et a préalablement été acceptée par l'utilisateur ;
- etc.

Côté utilisateur, la connaissance de l'information apportée par la désagrégation de charges permet à cet utilisateur, via un affichage sur un dispositif (par exemple un smartphone, une tablette ou un dispositif dédié) :
- de détecter des appareils électriques énergivores ;
- d'estimer sa consommation et sa facturation, notamment en vue de changer son attitude de consommation (par exemple, le fait de connaître la consommation de puissance de chaque appareil actif sur le réseau électrique de son foyer permet à l'utilisateur de détecter l'appareil le plus consommateur en puissance et déplacer le temps de son utilisation vers les périodes où le prix du kWh est le moins cher) ;
- d'estimer la variation de la consommation de puissance des appareils électriques, afin de détecter une surconsommation des appareils usés ;
- etc.

Une solution connue actuelle de désagrégation de charges utilise une détection de l'empreinte énergétique basée sur un modèle de Markov caché (ou HMM pour « Hidden Markov Model » en anglais). Cette solution connue actuelle est intéressante car il s'agit d'une technique de surveillance non intrusive de la charge (ou NILM pour « Non-Intrusive Load Monitoring » en anglais), qui bénéficie d'une forte acceptation par les utilisateurs et d'un faible coût de mise en œuvre par rapport aux solutions connues antérieures de désagrégation de charges qui étaient invasives. Toutefois, la solution connue actuelle de désagrégation de charges n'est pas entièrement satisfaisante car elle présente plusieurs inconvénients. Premièrement, le HMM présente une limitation lors de l'estimation de la puissance des appareils à plusieurs états de fonctionnement. Deuxièmement, son pouvoir à modéliser les dépendances entre les données séquentielles (reflétant les habitudes d'utilisation des appareils par exemple) est limitée. En effet, le HMM se base uniquement sur l'état antérieur pour pouvoir estimer la charge à l'instant t. De plus, la complexité calculatoire augmente exponentiellement avec le nombre d'appareils électriques à considérer par la désagrégation de charge.

Il existe donc un besoin de fournir une nouvelle solution de désagrégation de charges qui ne présente pas les inconvénients précités de la solution connue actuelle.

### EXPOSE DE L'INVENTION

Il est proposé un procédé de désagrégation de charges, implémenté par un système de désagrégation de charges comprenant une circuiterie électronique, le procédé comportant une phase opérationnelle comprenant :
- dans chaque branche de calcul i parmi M branches de calcul exécutées en parallèle et configurées chacune pour un type i d'appareil électrique parmi M types, avec M ≥ 2 et 0 < i ≤ M, effectuer :
   ∘ une première classification comprenant :
      * obtenir des premières mesures d'une consommation de puissance d'un foyer, fournies pendant un premier intervalle de temps par un compteur d'électricité communicant situé en entrée d'un réseau électrique du foyer ;
      * injecter les premières mesures dans un premier modèle d'apprentissage automatique de type réseau de neurones profond, configuré pour fournir pendant le premier intervalle de temps, en fonction des premières mesures, des premières valeurs estimées successives d'un état de fonctionnement d'un appareil électrique du type i ; et
      * décider, en fonction des premières valeurs estimées successives, si un appareil électrique du type i est présent sur le réseau électrique du foyer ;
   ∘ si la première classification aboutit à une décision qu'un appareil électrique du type i est présent sur le réseau électrique du foyer :
      * une deuxième classification comprenant :
         - obtenir N deuxièmes mesures de la consommation de puissance du foyer, fournies pendant un deuxième intervalle de temps, postérieur au premier intervalle de temps, par le compteur d'électricité communicant, avec N > 2 ;
         - injecter les N deuxièmes mesures dans un deuxième modèle d'apprentissage automatique de type réseau de neurones profond, configuré pour fournir, en fonction des N deuxièmes mesures, une deuxième valeur estimée d'un état de fonctionnement de l'appareil électrique du type i ;
      * une estimation de consommation de puissance individuelle de l'appareil électrique du type i, comprenant : injecter les N deuxièmes mesures de la consommation de puissance du foyer et la deuxième valeur estimée de l'état de fonctionnement de l'appareil électrique du type i, dans un troisième modèle d'apprentissage automatique de type réseau de neurones profond, configuré pour fournir une valeur estimée de la consommation de puissance individuelle de l'appareil électrique du type i, en fonction des N deuxièmes mesures et de la deuxième valeur estimée de l'état de fonctionnement de l'appareil électrique du type i ; et
- concaténer, dans un vecteur de sortie, M valeurs estimées de consommation de puissance individuelle associées aux M branches de calcul, une valeur estimée de consommation de puissance individuelle associée à une branche de calcul i étant égale à une consommation nulle, respectivement à la valeur estimée fournie par le troisième modèle d'apprentissage automatique de la branche de calcul i, quand la première classification de la branche de calcul i délivre une décision d'absence, respectivement une décision de présence, d'un appareil électrique du type i.

Ainsi, grâce à son architecture en parallèle, comprenant M branches de calcul qui s'exécutent en parallèle, la solution proposée permet de détecter simultanément la présence de plusieurs appareils électriques (jusqu'à M appareils électriques chacun d'un type distinct) et d'estimer la consommation de puissance individuelle de chacun. Les calculs sont réduits du fait que dans chaque branche de calcul, les opérations qui suivent la première classification ne sont effectuées que s'il découle de cette première classification qu'un appareil électrique (du type traité par la branche concernée) est détecté comme présent. En outre ces opérations peuvent être différentes d'une branche à l'autre, ce qui permet de s'adapter au mieux dans chaque branche au type d'appareil électrique qui y est traité.

Selon un mode de réalisation particulier, l'injection des premières mesures dans le premier modèle d'apprentissage automatique comprend K itérations, avec K > 2, d'une injection de N' premières mesures dans le premier modèle d'apprentissage automatique, configuré pour fournir, en fonction des N' premières mesures, une première valeur estimée d'un état de fonctionnement d'un appareil électrique du type i ; et la décision relative à la présence d'un appareil électrique du type i sur le réseau électrique du foyer est fonction des K premières valeurs estimées successives résultant des K itérations.

Selon un mode de réalisation particulier, dans chaque branche de calcul i, la première classification est répétée périodiquement, avec une période prédéterminée entre deux itérations.

Selon un mode de réalisation particulier, dans chaque branche de calcul i, au moins deux itérations de la deuxième classification , de l'estimation de consommation de puissance individuelle de l'appareil électrique du type i et de la concaténation sont effectuées, une nouvelle itération étant effectuée quand une nouvelle deuxième mesure est fournie par le compteur d'électricité communicant, les N deuxièmes mesures obtenues lors de la nouvelle itération comprenant la nouvelle deuxième mesure et N-1 deuxièmes mesures qui précèdent la nouvelle deuxième mesure.

Selon un mode de réalisation particulier, pour au moins une des branches de calcul, le troisième modèle d'apprentissage automatique de type réseau de neurones profond est un modèle d'auto-encodeur variationnel comprenant un encodeur utilisant un premier réseau de neurones récurrent et un décodeur utilisant un deuxième réseau de neurones récurrent.

Selon un mode de réalisation particulier, la phase opérationnelle comprend : transmettre le vecteur de sortie à au moins un équipement appartenant au groupe comprenant un équipement utilisé par un membre du foyer et un équipement d'un fournisseur d'électricité alimentant le foyer, en vue de déclencher au moins une action visant à agir sur une consommation de puissance future d'au moins un des appareils électriques du foyer ou sur une charge globale future, planifiée et gérée par le fournisseur d'électricité et incluant une consommation de puissance future du foyer.

Selon un mode de réalisation particulier, ladite au moins une action appartient au groupe comprenant :
- un affichage des états de fonctionnement et de la consommation de puissance individuelle de chaque appareil électrique du foyer ;
- une construction d'un historique de fonctionnement de chaque appareil électrique du foyer ;
- une prédiction d'une consommation de puissance future du foyer ;
- une détection d'une déficience d'un des appareils électriques du foyer ;
- un déplacement de la charge globale future, planifiée et gérée par le fournisseur d'électricité ; et
- un délestage partiel de la charge globale future, planifiée et gérée par le fournisseur d'électricité.

Selon un mode de réalisation particulier, dans chaque branche de calcul i, l'estimation de consommation de puissance individuelle de l'appareil électrique du type i comprend :
- appliquer un filtre adaptif aux N deuxièmes mesures de la consommation de puissance du foyer, pour obtenir N deuxièmes mesures filtrées ; et
- injecter les N deuxièmes mesures filtrées et la deuxième valeur estimée de l'état de fonctionnement de l'appareil électrique du type i, dans le troisième modèle d'apprentissage automatique de type réseau de neurones profond, configuré pour fournir la valeur estimée de la consommation de puissance individuelle de l'appareil électrique du type i, en fonction des N deuxièmes mesures filtrées et de la deuxième valeur estimée (c'est-à-dire le résultat de la deuxième classification).

Selon un mode de réalisation particulier, le procédé comporte une phase d'ajustement comprenant, pour le filtre adaptatif d'une branche de calcul i, après une phase d'apprentissage du troisième modèle d'apprentissage automatique de la branche de calcul i et avant la phase opérationnelle utilisant le filtre adaptatif de la branche de calcul i :
- utiliser le troisième modèle d'apprentissage automatique de la branche de calcul i, avec au moins une donnée d'apprentissage filtrée par le filtre adaptatif et associée à une étiquette de sortie, pour obtenir une valeur estimée de la consommation de puissance individuelle de l'appareil électrique du type i, dite valeur estimée de consommation ;
- comparer la valeur estimée de consommation avec l'étiquette de sortie ; et
- ajuster des coefficients du filtre adaptatif en fonction d'un résultat de la comparaison entre la valeur estimée de consommation et l'étiquette de sortie.

Selon un mode de réalisation particulier, le procédé comporte une phase d'apprentissage comprenant, pour un apprentissage du troisième modèle d'apprentissage automatique d'au moins une des branches de calcul :
- générer des données d'apprentissage non réelles avec un modèle de réseaux antagonistes génératifs, comprenant un générateur utilisant un premier réseau de neurones récurrent et un discriminateur utilisant un deuxième réseau de neurones récurrent ;
- construire un jeu de données d'apprentissage augmenté, en ajoutant les données d'apprentissage non réelles à des données d'apprentissage réelles collectées ; et
- effectuer un apprentissage du troisième modèle d'apprentissage automatique avec le jeu de données d'apprentissage augmenté.

Selon un mode de réalisation particulier, le procédé comporte une phase de mise à jour comprenant, pour une mise à jour du troisième modèle d'apprentissage automatique d'au moins une des branches de calcul :
- identifier un modèle le plus proche, parmi une pluralité de modèles de référence, en effectuant une corrélation entre d'une part la valeur estimée fournie par le troisième modèle d'apprentissage automatique pendant la phase opérationnelle et d'autre part des valeurs estimées fournies par la pluralité de modèles de référence après injection de données identiques à des données injectées dans le troisième modèle d'apprentissage automatique pendant la phase opérationnelle ; et
- réaliser un nouvel apprentissage du troisième modèle d'apprentissage automatique, avec un nouveau jeu de données d'apprentissage préalablement généré avec le modèle le plus proche.

Il est aussi proposé un produit programme d'ordinateur, comportant des instructions entraînant l'exécution, par un processeur, du procédé de désagrégation de charges évoqué ci-dessus selon l'un quelconque de ses modes de réalisation, lorsque lesdites instructions sont exécutées par le processeur.

Il est aussi proposé un support de stockage, stockant de telles instructions.

Il est aussi proposé un système de désagrégation de charges comportant une circuiterie électronique configurée pour implémenter le procédé de désagrégation de charges évoqué ci-dessus selon l'un quelconque de ses modes de réalisation.

Il est aussi proposé un compteur d'électricité communicant comprenant le système de désagrégation de charges évoqué ci-dessus.

### BREVE DESCRIPTION DES DESSINS

Les caractéristiques de l'invention mentionnées ci-dessus, ainsi que d'autres, apparaîtront plus clairement à la lecture de la description suivante d'au moins un exemple de réalisation, ladite description étant faite en relation avec les dessins joints, parmi lesquels :
[Fig. 1] illustre schématiquement un compteur d'électricité communicant configuré pour exécuter un procédé de désagrégation de charges selon un mode de réalisation de l'invention ;
[Fig. 2] illustre schématiquement un exemple d'architecture matérielle du compteur d'électricité communicant de la Fig. 1 ;
[Fig. 3] illustre schématiquement une variante dans laquelle le procédé de désagrégation de charges est exécuté dans l'informatique en nuage (« cloud computing » en anglais) ;
[Fig. 4] illustre schématiquement une première représentation d'une phase opérationnelle du procédé de désagrégation de charges, dans un mode de réalisation ;
[Fig. 5] illustre schématiquement une deuxième représentation de la phase opérationnelle du procédé de désagrégation de charges, qui précise et complète la première représentation de la Fig. 4 ;
[Fig. 6] illustre schématiquement un exemple d'algorithme d'itération de la première classification apparaissant sur la Fig. 4 ;
[Fig. 7] illustre schématiquement une implémentation particulière du modèle d'estimation de consommation de puissance individuelle apparaissant sur la Fig. 5 ;
[Fig. 8] illustre schématiquement une représentation d'une phase d'ajustement des coefficients de chaque filtre adaptatif apparaissant sur la Fig. 5 ;
[Fig. 9] illustre schématiquement une représentation d'une phase d'apprentissage de chaque modèle d'estimation de consommation de puissance individuelle apparaissant sur la Fig. 5 ;
[Fig. 10] illustre schématiquement une implémentation particulière de l'étape de génération de données d'apprentissage non réelles, apparaissant sur la Fig. 9 ; et
[Fig. 11] illustre schématiquement une représentation d'une phase de mise à jour de chaque modèle d'estimation de consommation de puissance individuelle apparaissant sur la Fig. 5.

### EXPOSE DETAILLE DE MODES DE REALISATION

### Résumé

La présente invention définit une solution pour la désagrégation de charges. Il s'agit d'une solution d'intelligence artificielle qui peut être implémentée dans un compteur d'électricité communicant (on parle alors d'une implémentation au niveau de l'informatique en périphérie de réseau, ou « Edge Computing » en anglais). Dans une variante, la solution proposée peut également être implémentée dans l'informatique en nuage, ou « Cloud Computing » en anglais. Quelle que soit l'implémentation, la solution proposée permet d'une part d'auto-détecter, derrière le compteur d'électricité communicant, des appareils électriques présents (comme les panneaux solaires, les chargeurs de voitures électriques, les appareils électroménagers, etc.) et d'autre part d'estimer la consommation de puissance de chaque appareil électrique détecté. Dans un mode de réalisation particulier, elle comporte plusieurs phases de fonctionnement : une phase d'apprentissage (aussi appelée « phase d'entraînement ») de modèles utilisés pendant la phase opérationnelle, une phase d'ajustement de coefficients de filtres adaptatifs utilisés dans la phase opérationnelle pour minimiser les bruits de mesures de la puissance, une phase opérationnelle (aussi appelée « phase fonctionnelle ») et une phase de mise à jour de modèles d'estimation de consommation de puissance individuelle.

La phase d'apprentissage consiste à préparer les solutions d'intelligence artificielle (c'est-à-dire les différents modèles d'apprentissage automatique, ou « Machine Learning » en anglais) utilisées ensuite durant la phase opérationnelle. Dans un mode de réalisation particulier, outre des opérations d'apprentissage conventionnelles, la phase d'apprentissage propose l'utilisation de l'augmentation des données afin d'améliorer la précision de l'estimation de la consommation de puissance ou de réduire le temps d'enregistrement des données d'apprentissage nécessaires pour la construction d'un jeu de données d'apprentissage (« training dataset » en anglais) fiable.

La phase opérationnelle permet de détecter l'état de fonctionnement des appareils électriques et d'estimer leurs consommations de puissance individuelles. Dans un mode de réalisation particulier, cette phase s'appuie sur une architecture comprenant M branches de calcul qui s'exécutent en parallèle, chaque branche étant dédiée à un type d'appareil et utilisant :
- une double classification comprenant une première classification, afin de détecter la présence d'un appareil électrique du type concerné derrière le compteur d'électricité, et une deuxième classification, afin de détecter les évènements de fonctionnement d'un appareil du type concerné s'il a été détecté ;
- un modèle spécifique d'estimation de consommation de puissance individuelle, pour la désagrégation de charges ;
- l'activation ou la désactivation du reste de la branche (c'est-à-dire la deuxième classification et le modèle spécifique d'estimation de consommation de puissance individuelle) en fonction du résultat de l'auto-détection assurée par la première classification ; et
- un filtre adaptatif pour renforcer l'estimation fournie par le modèle d'estimation de consommation de puissance individuelle.

La phase de mise à jour effectue, pour chacune des branches de calcul précitées, une mise à jour du modèle d'estimation de consommation de puissance individuelle, avec pour objectif d'améliorer l'estimation fournie.

Ces différentes phases sont présentées plus en détail ci-dessous.

Dans un mode de réalisation particulier, la solution proposée s'applique aux appareils électriques de type I et type II. Un appareil électrique de type I est un appareil dont les seuls états de fonctionnement possibles sont « Marche » et « Arrêt » (respectivement « ON » et « OFF » en anglais). Un exemple d'appareil électrique de type I est la lampe électrique. Un appareil électrique de type II est un appareil dont le fonctionnement est régi par une machine d'état et a donc différents états de fonctionnement (dont au moins un état de fonctionnement autre que « ON » et « OFF »). Un exemple d'appareil électrique de type II est le lave-linge.

Cas où le procédé de désagrégation de charges est exécuté dans le compteur d'électricité

Dans une première implémentation, la solution de désagrégation de charges proposée est implémentée dans un compteur d'électricité communicant, c'est-à-dire au niveau de 1'« Edge Computing ».

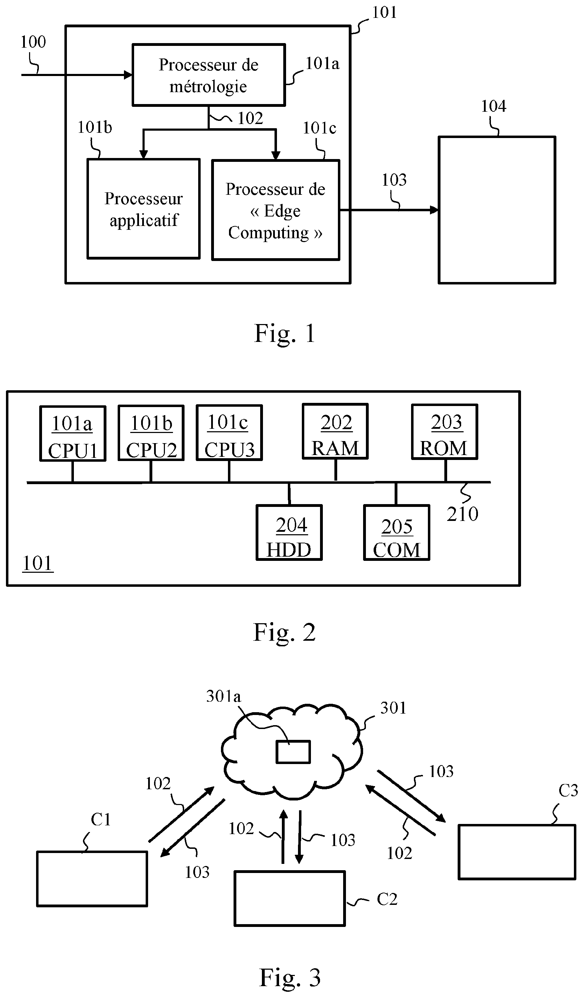

Dans l'exemple de la **Fig. 1****,** le compteur d'électricité communicant 101 comprend trois processeurs coopérant entre eux :
- un processeur de métrologie 101a, permettant d'échantillonner le signal analogique d'entrée 100 afin de fournir des échantillons (notamment des mesures successives 102, par exemple chaque seconde, de la consommation de puissance du foyer) aux deux autres processeurs, à savoir un processeur applicatif 101b et un processeur d'« Edge Computing » 101c ;
- le processeur applicatif 101b a pour rôle d'assurer le calcul des différentes empreintes énergétique du foyer. Il permet aussi d'intégrer un protocole applicatif pour les applications de comptage intelligent (« Smart Metering » en anglais) (par exemple : DLMS/COSEM, IEEE1377/ANSI C12.19, CLC/FprTS 50568-5, ...) ; et
- le processeur d'« Edge Computing » 101c est dédié au traitement des solutions d'intelligence artificielle et des applications de métrologie.

Plus précisément, le processeur d'« Edge Computing » 101c implémente la solution de désagrégation de charges proposée qui permet, en fonction des mesures successives 102 de la consommation de puissance du foyer, de fournir (par exemple chaque seconde) une information de désagrégation de charges 103 (information comprenant la liste des appareils détectés et pour chacun de ceux-ci la consommation de puissance individuelle). Le processeur d'« Edge Computing » 101c transmet cette information 103 à un équipement local 104 (par exemple un équipement d'affichage) ou à un équipement distant (par exemple un serveur de stockage et traitement situé dans le « Cloud Computing »), à travers un protocole de communication. Ce protocole de communication est par exemple le WiFi pour les réseaux domestiques (ou HAN pour « Home Area Network » en anglais) et le Wi-SUN pour les réseaux de terrain (ou FAN pour « Field Area Network » en anglais).

Le compteur d'électricité 101, dont l'architecture est représentée par la Fig. 1, permet d'interagir parfaitement dans un contexte de réseau électrique intelligent (« Smart Grid » en anglais), où le processeur d'« Edge Computing » 101c est le cœur pour assurer multiples solutions alliant à la fois l'Internet des objets (ou IoT pour « Internet of Things » en anglais) à l'intelligence artificielle. Ceci lui permet d'interagir avec différents capteurs ou différents centres de données des fournisseurs d'électricité.

La **Fig. 2** illustre schématiquement un exemple d'architecture matérielle du compteur d'électricité communicant 101 de la Fig. 1, qui comprend alors, reliés par un bus de communication 210 : les trois processeurs précités (processeur de métrologie 101a, processeur applicatif 101b et processeur d'« Edge computing » 101c, aussi notés CPU1, CPU2 et CPU3) ; une mémoire vive de type RAM (« Random Access Memory » en anglais) 202 ; une mémoire morte de type ROM (« Read Only Memory » en anglais) 203, par exemple une mémoire Flash ; un dispositif de stockage de données, tel qu'un disque dur HDD (« Hard Disk Drive » en anglais), ou un lecteur de support de stockage, tel qu'un lecteur de cartes SD (« Secure Digital » en anglais) 204 ; au moins une interface de communication 205 permettant au compteur 101 d'interagir notamment avec l'équipement local 104 ou un équipement distant dans le « Cloud Computing ».

La mémoire morte de type ROM 203 stocke les logiciels (instructions) exécutés par les différents processeurs 101a, 101b et 101c. Elle est également utilisée pour stocker les différents modèles d'intelligence artificielle (modèles d'apprentissage automatique) relatifs à la désagrégation de charges, ainsi que d'éventuels autres logiciels d'utilisation des réseaux électriques intelligents qui nécessitent un traitement au niveau du compteur d'électricité.

En particulier, le processeur d'« Edge computing » 100c est capable d'exécuter des instructions chargées dans la RAM 202 à partir de la ROM 203, d'une mémoire externe (non représentée), d'un support de stockage, tel qu'une carte SD, ou d'un réseau de communication (non représenté). Lorsque le compteur 101 est mis sous tension, le processeur d'« Edge computing » 100c est capable de lire de la RAM 202 des instructions et de les exécuter. Ces instructions forment un programme d'ordinateur causant la mise en œuvre, par le processeur 100c, des comportements, étapes et algorithme décrits ici (procédé de désagrégation de charges).

Tout ou partie des comportements, étapes et algorithme décrits ici peut ainsi être implémenté sous forme logicielle par exécution d'un ensemble d'instructions par une machine programmable, telle qu'un DSP (« Digital Signal Processor » en anglais) ou un microcontrôleur, ou être implémenté sous forme matérielle par une machine ou un composant (« chip » en anglais) dédié ou un ensemble de composants (« chipset » en anglais) dédié, tel qu'un FPGA (« Field-Programmable Gate Array » en anglais) ou un ASIC (« Application-Specific Integrated Circuit » en anglais). D'une manière générale, le compteur 101 comprend de la circuiterie électronique agencée et configurée pour implémenter les comportements, étapes et algorithmes décrits ici.

### Cas où le procédé de désagrégation de charges est exécuté dans le « cloud computing »

La **Fig. 3** illustre schématiquement une variante dans laquelle le procédé de désagrégation de charges est exécuté dans l'informatique en nuage (« cloud computing ») 301, par exemple dans un serveur distant 301a.

Dans ce cas, chacun des compteurs d'électricité communicants (référencés C1, C2 et C3 sur la Fig. 3) transmet ses mesures successives 102 de consommation de puissance du foyer au serveur distant 301a. Cette transmission peut être effectuée à une fréquence prédéterminée (par exemple chaque 5 minutes, chaque 15 minutes ou chaque heure). En retour, le serveur distant 301a transmet à chacun des compteurs le résultat de l'exécution du procédé de désagrégation de charges pour le compteur concerné (c'est-à-dire l'information de désagrégation de charges 103 pour ce compteur).

### Phase opérationnelle

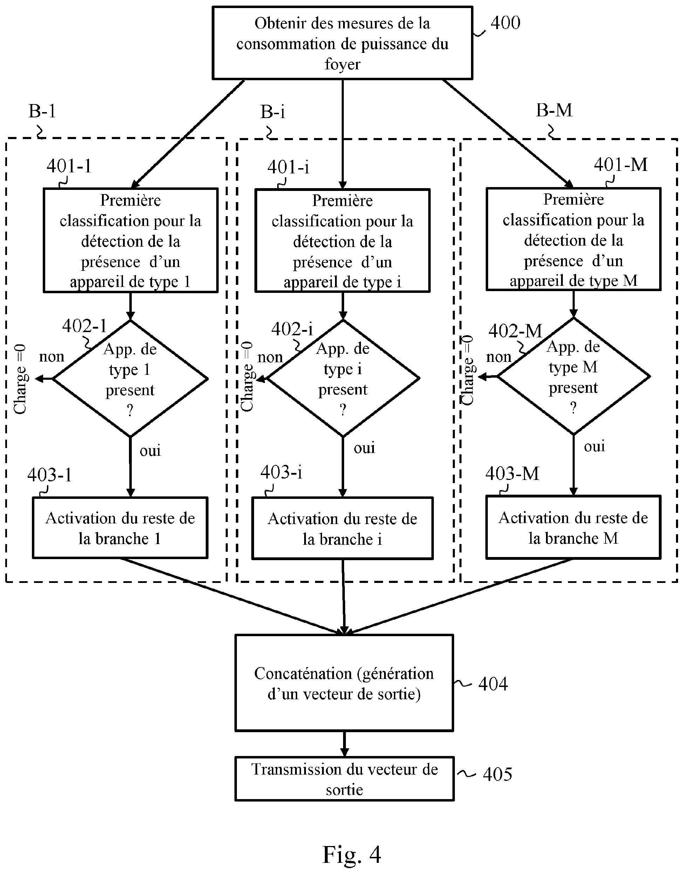

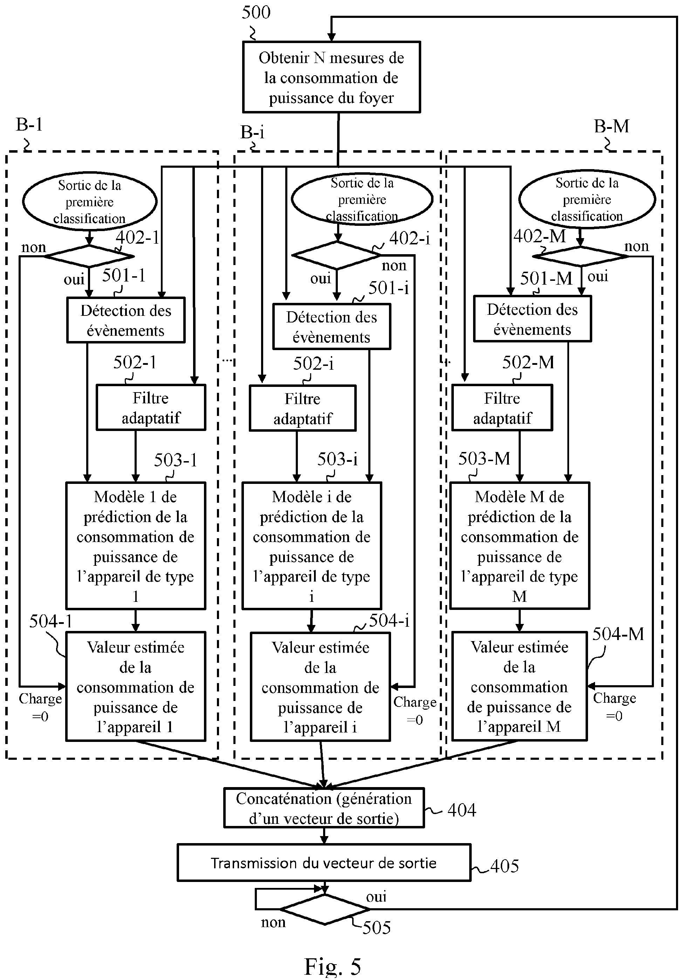

La démarche de la solution globale de désagrégation de charges est illustrée sur les Fig. 4 et 5. Cette solution permet d'assurer une désagrégation de charges, en parallèle, de plusieurs appareils électriques dans le même foyer, en utilisant une architecture sous forme de branches de calcul en parallèle. La solution de désagrégation de charges utilise comme entrée la consommation de puissance du foyer, et génère en sortie un résultat sous forme de vecteur présentant l'estimation de la consommation de puissance individuelle d'un ensemble d'appareils électriques.

Plus précisément, la **Fig. 4** illustre schématiquement une première représentation de la phase opérationnelle du procédé de désagrégation de charges, dans un mode de réalisation. A titre d'exemple, on se place, dans la suite de la description, dans le cas de la première implémentation illustrée sur les Fig. 1 et 2, où le procédé est exécuté par le processeur 101c (processeur d'« Edge Computing »).

La phase opérationnelle comprend M branches de calcul (référencées B-1 à B-M) qui s'exécutent en parallèle, avec M ≥ 2 (c'est-à-dire M est un nombre entier positif non nul). Chaque branche de calcul i, avec 0 < i ≤ M, est configurée pour un type i d'appareil électrique parmi M types. Par exemple, M = 30.

Dans chaque branche de calcul i, le processeur 101c effectue tout d'abord une première classification dans laquelle :
- dans une étape 400 (commune aux M branches de calcul), le processeur 101c obtient des premières mesures (référencées 102 sur la Fig. 1) de la consommation de puissance du foyer, fournies pendant un premier intervalle de temps (par exemple de l'ordre de quelques minutes à quelques jours) par le processeur de métrologie 101a ;
- dans une étape 401-i (spécifique à la branche de calcul i), le processeur 101c injecte les premières mesures dans un premier modèle d'apprentissage automatique de type réseau de neurones profond (« Deep Learning » en anglais), configuré pour fournir pendant le premier intervalle de temps, en fonction des premières mesures, des premières valeurs estimées successives d'un état de fonctionnement d'un appareil électrique du type i. En d'autres termes, le premier modèle est pré-entraîné pour le type d'appareil considéré dans la branche de calcul i ; et
- dans une étape 402-i (spécifique à la branche de calcul i), le processeur 101c décide, en fonction des premières valeurs estimées successives (par exemple en fonction de la durée et la continuité d'états de fonctionnement « ON » détectés), si un appareil électrique du type i est présent sur le réseau électrique du foyer.

Ainsi, à l'issue de l'exécution de la première classification dans chacune des M branches de calcul, le processeur 101c dispose pour chaque branche i d'une information de présence indiquant si un appareil électrique du type i est présent ou absent. La liste des appareils électriques détectés comme présents constitue une première partie de l'information de désagrégation de charges. Pour mémoire, la deuxième partie de l'information de désagrégation de charges est l'estimation de la consommation de puissance individuelle de chacun des appareils électriques détectés comme présents.

Dans chaque branche de calcul i, si la décision prise à l'étape 402-i est qu'un appareil électrique du type i est présent, le processeur 101c effectue l'opération référencée 403-i consistant à activer le reste de la branche de calcul B-i (c'est-à-dire, comme détaillé ci-dessous en relation avec la Fig. 5, une deuxième classification et une estimation de consommation de puissance individuelle) afin d'obtenir une valeur estimée de la consommation de puissance individuelle de l'appareil électrique de type i. En revanche, si la décision prise à l'étape 402-i est qu'un appareil électrique du type i n'est pas présent, le processeur 101c n'active pas le reste de la branche de calcul B-i et considère directement que la consommation de puissance individuelle de l'appareil électrique de type i est nulle.

Dans une étape 404, le processeur 101c concatène, dans un vecteur de sortie, les M valeurs estimées de consommation de puissance individuelle associées aux M branches de calcul. Comme expliqué plus haut, chaque valeur estimée est soit celle estimée par le reste de la branche si celui-ci a été activé (opération 403-i), soit nulle si le reste de la branche n'a pas été activé (réponse « non » au test 402-i). Ainsi, le vecteur de sortie contient les deux parties de l'information de désagrégation de charges 103 : la liste des appareils détectés contient les appareils électriques pour lesquels la consommation de puissance individuelle est nulle, et la consommation de puissance individuelle des appareils électriques détectés est donnée par les valeurs non nulles du vecteur de sortie.

Dans une étape 405, le processeur 101c transmet le vecteur de sortie à l'équipement local 104 ou à l'équipement distant (par exemple le serveur de stockage et traitement situé dans le « Cloud Computing »).

L'estimation de la consommation de puissance individuelle de chaque appareil électrique permet de construire son historique de fonctionnement. Cet historique peut être utilisé afin de mémoriser les habitudes de l'utilisateur, ce qui aidera le fournisseur d'électricité à mieux prédire la consommation de puissance sur son réseau national par exemple. De plus, cet historique permet de détecter l'usure de l'appareil en question et un changement de sa signature électrique. Ainsi, cela permet d'indiquer à l'utilisateur si les appareils détectés présents sur le réseau du foyer présentent une déficience et deviennent par exemple plus consommateur de puissance.

Plus généralement, le processeur 101c transmet le vecteur de sortie à au moins un équipement appartenant au groupe comprenant un équipement utilisé par un membre du foyer et un équipement d'un fournisseur d'électricité alimentant le foyer, en vue de déclencher au moins une action visant à agir sur une consommation de puissance future d'au moins un des appareils électriques du foyer ou sur une charge globale future, planifiée et gérée par le fournisseur d'électricité et incluant une consommation de puissance future du foyer. Une liste (non exhaustive) d'actions comprend par exemple : un affichage des états de fonctionnement et de la consommation de puissance individuelle de chaque appareil électrique du foyer ; une construction d'un historique de fonctionnement de chaque appareil électrique du foyer ; une prédiction d'une consommation de puissance future du foyer ; une détection d'une déficience d'un des appareils électriques du foyer ; un déplacement de la charge globale future, planifiée et gérée par le fournisseur d'électricité ; un délestage partiel de la charge globale future, planifiée et gérée par le fournisseur d'électricité ; etc.

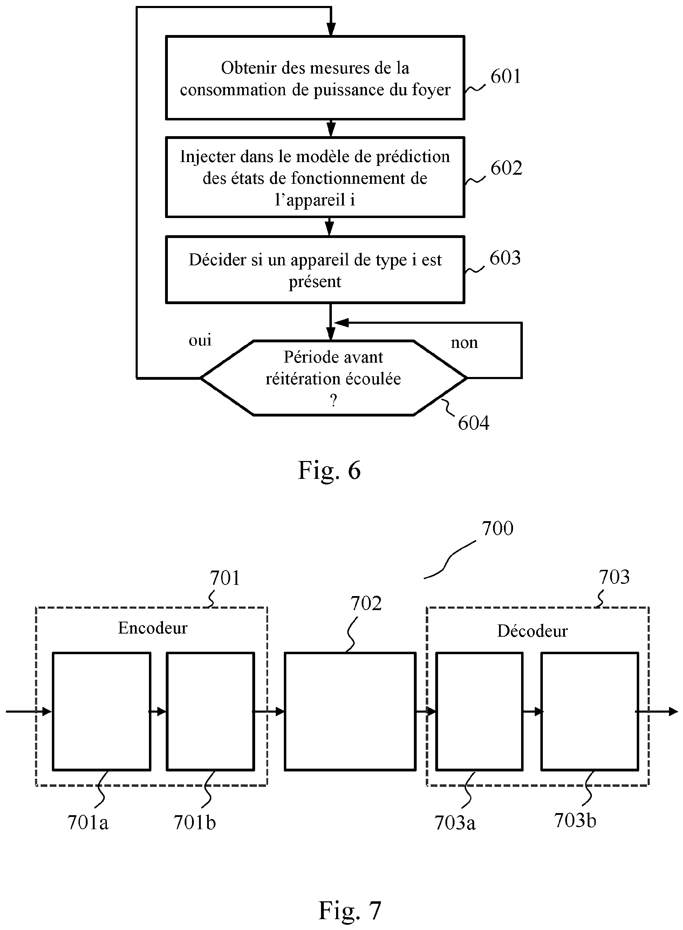

La Fig. 6 illustre schématiquement un exemple d'algorithme d'itération de la première classification 401-i de chaque branche de calcul i apparaissant sur la Fig. 4. En résumé, la première classification 401-i est répétée périodiquement, avec une période prédéterminée entre deux itérations. Plus précisément, après l'exécution des étapes 601, 602 et 603, correspondant respectivement aux étapes 400, 401-i et 402-i de la Fig.4, le processeur 101c exécute une étape de test 604 pour vérifier si une période prédéterminée avant réitération est écoulée. En cas de réponse négative à l'étape de test 604, le processeur 101c attend et effectue à nouveau le test jusqu'à obtenir une réponse positive. En cas de réponse positive à l'étape de test 604, le processeur 101c effectue une nouvelle itération des étapes 601, 602 et 603, c'est-à-dire exécute à nouveau la première classification dans chacune des M branches de calcul, de sorte que la liste des appareils électriques détectés comme présents (constituant la première partie de l'information de désagrégation de charges) peut être modifiée par rapport à l'itération précédente.

Dans un mode de réalisation particulier, l'étape 602 d'injection des premières mesures dans le premier modèle d'apprentissage automatique comprend K itérations, avec K > 2, d'une injection de N' premières mesures dans le premier modèle d'apprentissage automatique, configuré pour fournir, en fonction des N' premières mesures, une première valeur estimée d'un état de fonctionnement d'un appareil électrique du type i. En outre, l'étape 603 de décision relative à la présence d'un appareil électrique du type i sur le réseau électrique du foyer est fonction des K premières valeurs estimées successives résultant des K itérations. La **Fig. 5** illustre schématiquement une deuxième représentation de la phase opérationnelle du procédé de désagrégation de charges, qui précise et complète la première représentation de la Fig. 4.

Sur la Fig. 5, pour chaque branche de calcul i, on a détaillé l'opération référencée 403-i sur la Fig. 4 et consistant à activer le reste de la branche de calcul B-i quand la décision prise à l'étape 402-i est qu'un appareil électrique du type i est présent. Ainsi, si un appareil électrique du type i est détecté présent, le processeur 101c exécute une deuxième classification puis une estimation de consommation de puissance individuelle.

La deuxième classification comprend :
- une étape 500 (commune aux M branches de calcul), dans laquelle le processeur 101c obtient N deuxièmes mesures de la consommation de puissance du foyer, avec N > 2, fournies par le processeur de métrologie 101a pendant un deuxième intervalle de temps (par exemple une mesure chaque seconde pendant une fenêtre temporelle de N secondes) postérieur au premier intervalle de temps mentionné plus haut (voir étape 400 de la Fig. 4) ; et
- une étape 501-i (spécifique à la branche de calcul i), dans laquelle le processeur 101c injecte les N mesures dans un deuxième modèle d'apprentissage automatique de type réseau de neurones profond (« Deep Learning »), configuré pour fournir, en fonction des N deuxièmes mesures, une valeur estimée d'un état de fonctionnement de l'appareil électrique du type i.

La deuxième classification exécutée par le processeur 101c au niveau de chaque branche de calcul i permet d'améliorer la qualité de l'estimation (prédiction) de la consommation de puissance de chaque appareil, effectuée dans l'étape 503-i décrite plus bas. En effet, la solution de désagrégation de charges utilise la détection des événements pour être capable de prédire au plus près la consommation de puissance individuelle de chaque appareil électrique.

Le deuxième modèle de type réseau de neurones profond comprend par exemple une succession de couches convolutionnelles permettant de séparer les évènements observés sur la consommation de puissance globale du foyer.

La deuxième phase de classification permet de détecter l'état « ON » ou « OFF » des appareils électriques de type I ou les différentes phases de fonctionnement des appareils électriques de type II.

Lors de l'estimation de consommation de puissance individuelle (étape référencée 503-i sur la Fig. 5), le processeur 101c injecte les N mesures de la consommation de puissance du foyer (obtenues à l'étape 500), ainsi que la valeur estimée de l'état de fonctionnement de l'appareil électrique du type i (obtenue à l'étape 501-i), dans un troisième modèle d'apprentissage automatique de type réseau de neurones profond (« Deep Learning »), configuré pour fournir une valeur estimée de la consommation de puissance individuelle de l'appareil électrique du type i, en fonction des N mesures et de la valeur estimée de l'état de fonctionnement de l'appareil électrique du type i.

Dans une variante illustrée sur la Fig. 5, pour chaque branche de calcul i, le processeur 101c applique, dans une étape 502-i, un filtre adaptif aux N deuxièmes mesures de la consommation de puissance du foyer, pour obtenir N deuxièmes mesures filtrées. Ce filtrage adaptatif permet d'éliminer les bruits de mesures sur le réseau électrique, les perturbations sur le signal et les effets transitoires. Dans cette variante, ce sont ces N mesures filtrées (obtenues à l'étape 502-i) qui sont injectées, avec la valeur estimée de l'état de fonctionnement de l'appareil électrique du type i (obtenue à l'étape 501-i), dans le troisième modèle utilisé à l'étape 503-i.

La Fig. 7 illustre schématiquement une implémentation particulière du troisième modèle utilisé à l'étape 503-i de la Fig. 5. Il s'agit d'un modèle d'auto-encodeur variationnel 700 comprenant :
- un encodeur 701 utilisant une couche convolutionnelle 701a suivie un premier réseau de neurones récurrent 701b. L'encodeur 701 permet de compresser et de former l'espace latent de la consommation de puissance globale du foyer qui se présente sous forme de variable aléatoire d'entrée. La couche convolutionnelle 701a permet de dégager les caractéristiques les plus importante du signal en entrée. Le réseau de neurones récurrents 701b permet de dégager les dépendances temporelles entre les caractéristiques relevées ;
- une couche personnalisée 702 pour un échantillonnage stochastique. Elle a pour but de forcer la distribution de l'espace latent en gaussienne. Les variables latentes gaussiennes sont l'entrée du décodeur 703. La distribution gaussienne permet d'aider le modèle à converger plus rapidement vers une solution. Ceci permet une meilleure précision à la sortie du troisième modèle ; et
- un décodeur 703 utilisant un deuxième réseau de neurones récurrent 703a suivi d'une couche convolutionnelle 703b. Le décodeur 703 permet de décoder à partir des variables latentes la consommation de puissance individuelle de l'appareil en question. Il utilise une architecture inverse de l'encodeur 701.

Le modèle d'auto-encodeur variationnel permet de générer une variable aléatoire (dans notre cas la consommation de puissance individuelle de l'appareil i considéré) induite d'une autre variable aléatoire (dans notre cas la consommation de puissance globale du foyer). Il permet de transformer ce genre de problème en un problème d'optimisation statistique en utilisant l'espace latent des variables d'entrée. L'utilisation des réseaux de neurones récurrents 701b et 703a ajoutent la capacité de traiter les données temporelles et séquentielles telles la consommation périodique de la puissance électrique. Afin d'optimiser la phase d'entraînement en aidant le modèle à converger rapidement, une distribution gaussienne des variables latentes est choisie. L'amélioration de la convergence permet un meilleur entraînement et un résultat plus précis de l'estimation de puissance de chaque appareil. A la sortie de l'encodeur 701, afin d'avoir une distribution gaussienne, une re-paramétrisation de l'espace latent de la variable d'entrée est fait par échantillonnage stochastique. Ce type d'échantillonnage force les variables à prendre une distribution gaussienne et aide ainsi le décodeur 703 à converger plus rapidement. L'étape d'échantillonnage est modélisée par la couche personnalisée 702. Les tailles de l'encodeur 701 et du décodeur 702 sont choisies pour offrir une moindre complexité. Ce choix consiste par exemple en l'étude de la variation de la précision obtenue par le modèle de désagrégation de charges (pour chaque branche de calcul i) en fonction de la complexité de son architecture notamment en fonction des nombres de neurones. La réduction maximale du nombre de neurones permet ainsi de réduire l'espace mémoire nécessaire pour l'implémentation de la solution. Pour quelques types d'appareils électriques considérés, on utilise par exemple des réseaux récurrents ayant environ 40 neurones nécessitant une mémoire ROM de l'ordre de 0,5 MB.

Bien que le modèle proposé ci-dessus, d'auto-encodeur variationnel basé sur les réseaux de neurones récurrents, est très performant, l'architecture de la solution proposée peut également implémenter d'autres types de modèles, pouvant être différents d'une branche de calcul à l'autre.

Dans l'étape 504-i de la branche de calcul i, le processeur 101c détermine de la valeur estimée de la consommation de puissance individuelle de l'appareil électrique du type i : il s'agit soit de celle estimée à l'étape 503-i, si celle-ci a été exécutée, soit d'une valeur nulle si le reste de la branche n'a pas été activé (réponse « non » au test 402-i).

Après exécution (totale ou partielle, selon les résultats des étapes de test 402-i) des M branches de calcul, le processeur 101c exécute les étapes 404 et 405 également présentes sur la Fig. 4 et déjà décrites plus haut.

Enfin, le processeur 101c exécute une étape de test 505 pour vérifier si une nouvelle mesure de la consommation de puissance du foyer a été fournie par le processeur de métrologie 101a. En cas de réponse négative à l'étape de test 505, le processeur 101c attend et effectue à nouveau le test jusqu'à obtenir une réponse positive. En cas de réponse positive à l'étape de test 505, le processeur 101c effectue une nouvelle exécution de l'étape 500 (le nouveau jeu de N mesures comprend la nouvelle mesure et les N-1 précédentes mesures ; c'est-à-dire utilisation d'une fenêtre glissante de N mesures avec par exemple une nouvelle mesure par seconde), puis des étapes 402-i, 501-i, 503-i et 504-i des M branches de calcul ainsi que des étapes 404 et 405, de sorte qu'un nouveau vecteur de sortie est généré et transmis (chaque seconde dans le cas précité d'une fenêtre glissante de N mesures avec une nouvelle mesure par seconde).

Afin de résumer la phase opérationnelle, nous présentons dans ce qui suit un exemple d'utilisation. On suppose que la solution comportant trente branches de calcul (M = 30) supportant trente types d'appareils différents (un par branche).

Pendant une première période, et après l'installation du compteur d'électricité, une étape d'enregistrement des premières mesures de consommation de puissance du foyer est prévue.

La première période d'enregistrement est par exemple de quelques minutes à quelques jours et le compteur d'électricité fournit par exemple chaque seconde une mesure de la consommation de puissance du foyer. Une fois l'enregistrement réalisé (fin de la première période), la première classification pour la détection des appareils électriques est faite. On suppose que le résultat de la première classification démontre que des appareils de seize types, sur les trente types d'appareils détectables par les trente branches de calcul, sont branchés sur le réseau électrique du foyer.

Les quatorze branches de calcul dans lesquelles aucun appareil n'est détecté, c'est-à-dire correspondant à des appareils non reconnus, sont désactivées pour la suite. Leurs sorties sont égales à zéro (consommation de puissance individuelle nulle).

Les seize autres branches sont actives pour la suite. Dans chaque branche active, les N dernières valeurs (échantillons) lues sur le compteur (N valeurs de consommation de puissance du foyer) sont données en entrée. Supposons que N=10, alors les dix derniers échantillons forment l'entrée des deux blocs suivants de chaque branche : la deuxième classification et le filtrage adaptatif. La deuxième classification fournit l'état de fonctionnement de l'appareil à l'instant courant. Les mêmes dix valeurs sont filtrées grâce à l'utilisation du filtre adaptatif. La partie effectuant l'estimation de la consommation de puissance individuelle a comme entrée l'état de fonctionnement de l'appareil et les dix valeurs filtrées. La mise à jour des dix valeurs se fait par exemple sous forme de fenêtre glissante : on garde les neuf dernières valeurs et on ajoutera la prochaine valeur qui sera lue du compteur d'électricité. La deuxième classification, le filtrage et l'estimation de la consommation de puissance individuelle se font presque à temps réel juste, après la réception du dernier échantillon reçu par le compteur d'électricité afin de mettre à jour la fenêtre glissante comportant les N valeurs.

### Phase d'ajustement des coefficients des filtres adaptatifs

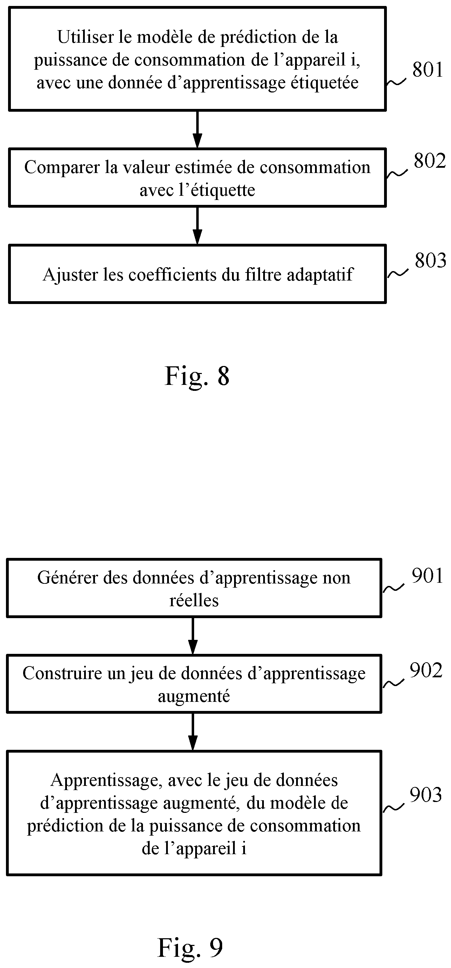

La Fig. 8 illustre schématiquement une représentation d'une phase d'ajustement des coefficients de chaque filtre adaptatif apparaissant sur la Fig. 5. Cette phase d'ajustement comprend, pour le filtre adaptatif 502-i d'une branche de calcul i, après la phase d'apprentissage du troisième modèle d'apprentissage automatique de la branche de calcul i et avant la phase opérationnelle utilisant le filtre adaptatif de la branche de calcul i :
- dans une étape 801, utiliser le troisième modèle d'apprentissage automatique de la branche de calcul i, avec au moins une donnée d'apprentissage filtrée par le filtre adaptatif et associée à une étiquette de sortie, pour obtenir une valeur estimée de la consommation de puissance individuelle de l'appareil électrique du type i, dite valeur estimée de consommation ;
- dans une étape 802, comparer la valeur estimée de consommation avec l'étiquette de sortie ; et
- dans une étape 803, ajuster des coefficients du filtre adaptatif en fonction d'un résultat de la comparaison entre la valeur estimée de consommation et l'étiquette de sortie.

L'ajustement des coefficients du filtre adaptatif de la branche de calcul i permet de renforcer l'estimation 503-i de la consommation de puissance de l'appareil électrique de type i. Un ensemble de coefficients est jugé valide si les données générées par le modèle d'estimation de la consommation de puissance après filtrage du signal d'entrée sont plus précises que celle générés avec un signal d'entrée non filtré. Ces coefficients de filtres sont gardés fixes tout au long de l'étape fonctionnelle. Un exemple de filtre pouvant être choisi lors de l'étape de fixation des coefficients est le filtre moyenneur.

### Phase d'apprentissage

Chacun des modèles utilisés dans la phase opérationnelle (voir étapes 401-i, 501-i et 503-i pour chaque branche de calcul i) doit passer par une phase d'entraînement. Vu que ces différents modèles s'intéressent à un seul type d'appareil par branche de calcul, la phase d'entraînement de chaque modèle prend en considération deux entrées : la consommation de puissance globale du foyer et la consommation de puissance du type de l'appareil i considéré par la branche i.

Certains modèles utilisés dans la solution de désagrégation de charges peuvent nécessiter de grandes quantités de données d'entraînement pour être précis et efficaces. Malheureusement, les données réelles d'un appareil électrique peuvent ne pas être représentatives de l'ensemble des appareils électriques similaires (c'est-à-dire du même type) qui fonctionnent dans le monde entier. Ce problème peut entraîner une baisse de la qualité des données pour l'entraînement du modèle d'IA. Afin de résoudre ce problème et de créer des modèles plus universels à partir des données d'entraînement limitées disponibles, il est proposé, dans un mode de réalisation particulier de l'invention, d'exploiter des modèles d'IA générative pour l'augmentation des données d'entraînement. En exploitant des modèles d'IA générative, la solution proposée peut créer efficacement des instances de données synthétiques qui imitent étroitement les caractéristiques d'échantillons du monde réel, ce qui réduit les efforts de collecte de données.

La **Fig. 9** illustre schématiquement une représentation d'une phase d'apprentissage de chaque modèle d'estimation de consommation de puissance individuelle apparaissant sur la

Fig. 5. Cette phase d'apprentissage comprend, pour un apprentissage du troisième modèle d'apprentissage automatique d'au moins une des branches de calcul :
- dans une étape 901, générer des données d'apprentissage non réelles avec un modèle de réseaux antagonistes génératifs, comprenant un générateur utilisant un premier réseau de neurones récurrent et un discriminateur utilisant un deuxième réseau de neurones récurrent ;
- dans une étape 902, construire un jeu de données d'apprentissage augmenté, en ajoutant les données d'apprentissage non réelles à des données d'apprentissage réelles collectées ; et
- dans une étape 903, effectuer un apprentissage du troisième modèle d'apprentissage automatique avec le jeu de données d'apprentissage augmenté.

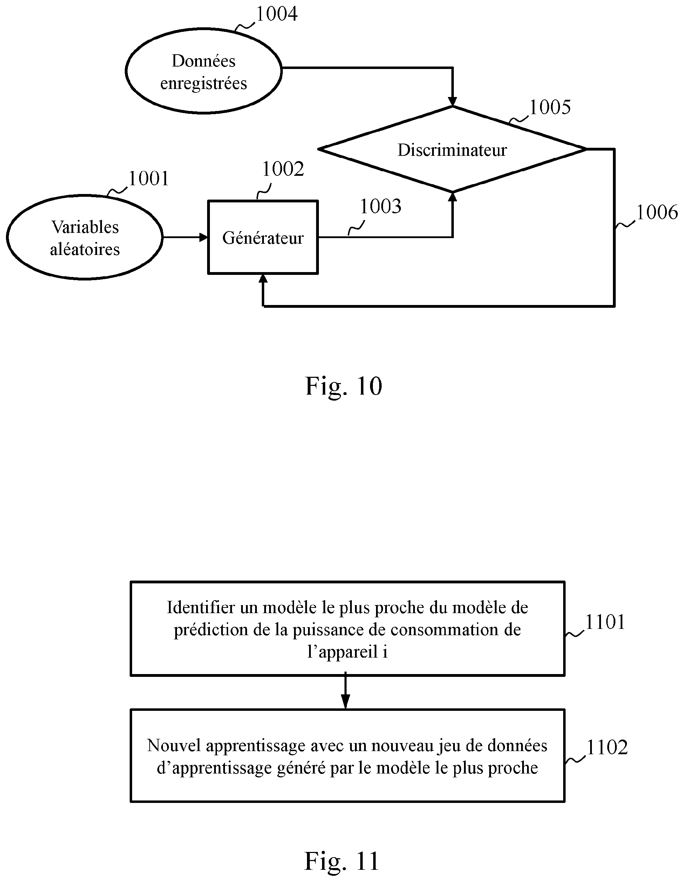

La **Fig. 10** illustre schématiquement une implémentation particulière de l'étape 901 de génération de données d'apprentissage non réelles, apparaissant sur la Fig. 9. Ainsi, il est proposé une solution d'augmentation de donnée qui repose sur un modèle de réseaux antagonistes génératifs, dans lequel deux réseaux de neurones récurrents forment respectivement le générateur 1002 et le discriminateur 1005. Le générateur 1002 permet la génération de données 1003 à partir d'entrées aléatoires 1001. Le discriminateur 1005 permet de juger si ces données 1003 sont réelles ou pas dans le but d'approcher au maximum l'aspect des données réelles 1004. Le générateur 1002 ainsi mis à jour (boucle de rétroaction 1006) est en mesure de générer les données augmentées.

Vu la nature de l'utilisation de quelques appareils électriques, certaines données collectées présentent beaucoup plus d'état d'inactivités que d'états de fonctionnement impactant plus de zéros sur les données. Les données relevées ou augmentées peuvent alors être déséquilibrées ne représentant pas les différents états de fonctionnements d'une façon égale. Afin de remédier à ce problème, un équilibrage par des données synthétiques est utilisé par un suréchantillonnage des états minoritaires. Cette technique est utilisée lors de l'entraînement hors ligne.

Phase de mise à jour des modèles d'estimation de consommation de puissance individuelle

La **Fig. 11** illustre schématiquement une représentation d'une phase de mise à jour de chaque modèle d'estimation de consommation de puissance individuelle apparaissant sur la Fig. 5. Cette phase de mise à jour comprend, pour une mise à jour du troisième modèle d'apprentissage automatique d'au moins une des branches de calcul :
- dans une étape 1101, identifier un modèle le plus proche, parmi une pluralité de modèles de référence, en effectuant une corrélation entre d'une part la valeur estimée fournie par le troisième modèle d'apprentissage automatique pendant la phase opérationnelle et d'autre part des valeurs estimées fournies par la pluralité de modèles de référence après injection de données identiques à des données injectées dans le troisième modèle d'apprentissage automatique pendant la phase opérationnelle ; et
- dans une étape 1102, réaliser un nouvel apprentissage du troisième modèle d'apprentissage automatique, avec un nouveau jeu de données d'apprentissage préalablement généré avec le modèle le plus proche.

Cette phase de mise à jour permet d'améliorer l'estimation de la consommation de puissance individuelle du type d'appareil de la branche de calcul considérée. Le troisième modèle de chaque branche, pour laquelle un appareil a été détecté présent sur le réseau du foyer, peut être affiné.

## Revendications

1. Procédé de désagrégation de charges, implémenté par un système de désagrégation de charges comprenant une circuiterie électronique, le procédé comportant une phase opérationnelle comprenant :
- dans chaque branche de calcul i (B-i) parmi M branches de calcul (B-1 à B-M) exécutées en parallèle et configurées chacune pour un type i d'appareil électrique parmi M types, avec M ≥ 2 et 0 < i ≤ M, effectuer :
∘ une première classification (401-i) comprenant :
* obtenir (400 ; 601) des premières mesures d'une consommation de puissance d'un foyer, fournies pendant un premier intervalle de temps par un compteur d'électricité communicant (101) situé en entrée d'un réseau électrique du foyer ;
* injecter (602) les premières mesures dans un premier modèle d'apprentissage automatique de type réseau de neurones profond, configuré pour fournir pendant le premier intervalle de temps, en fonction des premières mesures, des premières valeurs estimées successives d'un état de fonctionnement d'un appareil électrique du type i ; et
* décider (603), en fonction des premières valeurs estimées successives, si un appareil électrique du type i est présent sur le réseau électrique du foyer ;
∘ si la première classification aboutit à une décision qu'un appareil électrique du type i est présent sur le réseau électrique du foyer :
* une deuxième classification (501-i) comprenant :
• obtenir N deuxièmes mesures de la consommation de puissance du foyer, fournies pendant un deuxième intervalle de temps, postérieur au premier intervalle de temps, par le compteur d'électricité communicant, avec N > 2 ;
• injecter les N deuxièmes mesures dans un deuxième modèle d'apprentissage automatique de type réseau de neurones profond, configuré pour fournir, en fonction des N deuxièmes mesures, une deuxième valeur estimée d'un état de fonctionnement de l'appareil électrique du type i ;
* une estimation (503-i, 504-i) de consommation de puissance individuelle de l'appareil électrique du type i, comprenant : injecter les N deuxièmes mesures de la consommation de puissance du foyer et la deuxième valeur estimée de l'état de fonctionnement de l'appareil électrique du type i, dans un troisième modèle d'apprentissage automatique (503-i) de type réseau de neurones profond, configuré pour fournir une valeur estimée de la consommation de puissance individuelle de l'appareil électrique du type i, en fonction des N deuxièmes mesures et de la deuxième valeur estimée de l'état de fonctionnement de l'appareil électrique du type i ; et
- concaténer (404), dans un vecteur de sortie, M valeurs estimées de consommation de puissance individuelle associées aux M branches de calcul, une valeur estimée de consommation de puissance individuelle associée à une branche de calcul i étant égale à une consommation nulle, respectivement à la valeur estimée fournie par le troisième modèle d'apprentissage automatique de la branche de calcul i, quand la première classification de la branche de calcul i délivre une décision d'absence, respectivement une décision de présence, d'un appareil électrique du type i.

2. Procédé selon la revendication 1, dans lequel :
- l'injection (602) des premières mesures dans le premier modèle d'apprentissage automatique comprend K itérations, avec K > 2, d'une injection de N' premières mesures dans le premier modèle d'apprentissage automatique, configuré pour fournir, en fonction des N' premières mesures, une première valeur estimée d'un état de fonctionnement d'un appareil électrique du type i ; et
- la décision (603) relative à la présence d'un appareil électrique du type i sur le réseau électrique du foyer est fonction des K premières valeurs estimées successives résultant des K itérations.

3. Procédé selon l'une quelconque des revendications 1 et 2, dans lequel, dans chaque branche de calcul i, la première classification (401-i) est répétée périodiquement, avec une période prédéterminée entre deux itérations.

4. Procédé selon l'une quelconque des revendications 1 à 3, dans lequel, dans chaque branche de calcul i, au moins deux itérations de la deuxième classification (501-i), de l'estimation (503-i, 504-i) de consommation de puissance individuelle de l'appareil électrique du type i et de la concaténation (404) sont effectuées, une nouvelle itération étant effectuée quand une nouvelle deuxième mesure (505) est fournie par le compteur d'électricité communicant, les N deuxièmes mesures obtenues lors de la nouvelle itération comprenant la nouvelle deuxième mesure et N-1 deuxièmes mesures qui précèdent la nouvelle deuxième mesure.

5. Procédé selon l'une quelconque des revendications 1 à 4, dans lequel, pour au moins une des branches de calcul, le troisième modèle d'apprentissage automatique de type réseau de neurones profond est un modèle d'auto-encodeur variationnel (700) comprenant un encodeur (701) utilisant un premier réseau de neurones récurrent et un décodeur (702) utilisant un deuxième réseau de neurones récurrent.

6. Procédé selon l'une quelconque des revendications 1 à 5, dans lequel la phase opérationnelle comprend :
- transmettre (405) le vecteur de sortie à au moins un équipement (104) appartenant à un groupe comprenant un équipement utilisé par un membre du foyer et un équipement d'un fournisseur d'électricité alimentant le foyer, en vue de déclencher au moins une action visant à agir sur une consommation de puissance future d'au moins un des appareils électriques du foyer ou sur une charge globale future, planifiée et gérée par le fournisseur d'électricité et incluant une consommation de puissance future du foyer.

7. Procédé selon la revendication 6, dans lequel la au moins une action appartient au groupe comprenant :
- un affichage des états de fonctionnement et de la consommation de puissance individuelle de chaque appareil électrique du foyer ;
- une construction d'un historique de fonctionnement de chaque appareil électrique du foyer ;
- une prédiction d'une consommation de puissance future du foyer ;
- une détection d'une déficience d'un des appareils électriques du foyer ;
- un déplacement de la charge globale future, planifiée et gérée par le fournisseur d'électricité ; et
- un délestage partiel de la charge globale future, planifiée et gérée par le fournisseur d'électricité.

8. Procédé selon l'une quelconque des revendications 1 à 7, dans lequel, dans chaque branche de calcul i, l'estimation de consommation de puissance individuelle de l'appareil électrique du type i comprend :
- appliquer un filtre adaptif (502-i) aux N deuxièmes mesures de la consommation de puissance du foyer, pour obtenir N deuxièmes mesures filtrées ; et
- injecter les N deuxièmes mesures filtrées et la deuxième valeur estimée de l'état de fonctionnement de l'appareil électrique du type i, dans le troisième modèle (503-i) d'apprentissage automatique de type réseau de neurones profond, configuré pour fournir la valeur estimée de la consommation de puissance individuelle de l'appareil électrique du type i, en fonction des N deuxièmes mesures filtrées et de la deuxième valeur estimée.

9. Procédé selon la revendication 8, comportant une phase d'ajustement comprenant, pour le filtre adaptatif d'une branche de calcul i, après une phase d'apprentissage du troisième modèle d'apprentissage automatique de la branche de calcul i et avant la phase opérationnelle utilisant le filtre adaptatif de la branche de calcul i :
- utiliser (801) le troisième modèle d'apprentissage automatique de la branche de calcul i, avec au moins une donnée d'apprentissage filtrée par le filtre adaptatif et associée à une étiquette de sortie, pour obtenir une valeur estimée de la consommation de puissance individuelle de l'appareil électrique du type i, dite valeur estimée de consommation ;
- comparer (802) la valeur estimée de consommation avec l'étiquette de sortie ; et
- ajuster (803) des coefficients du filtre adaptatif en fonction d'un résultat de la comparaison entre la valeur estimée de consommation et l'étiquette de sortie.

10. Procédé selon l'une quelconque des revendications 1 à 9, comportant une phase d'apprentissage comprenant, pour un apprentissage du troisième modèle d'apprentissage automatique d'au moins une des branches de calcul :
- générer (901) des données d'apprentissage non réelles avec un modèle de réseaux antagonistes génératifs, comprenant un générateur utilisant un premier réseau de neurones récurrent et un discriminateur utilisant un deuxième réseau de neurones récurrent ;
- construire (902) un jeu de données d'apprentissage augmenté, en ajoutant les données d'apprentissage non réelles à des données d'apprentissage réelles collectées ; et
- effectuer (903) un apprentissage du troisième modèle d'apprentissage automatique avec le jeu de données d'apprentissage augmenté.

11. Procédé selon l'une quelconque des revendications 1 à 10, comportant une phase de mise à jour comprenant, pour une mise à jour du troisième modèle d'apprentissage automatique d'au moins une des branches de calcul :
- identifier (1101) un modèle le plus proche, parmi une pluralité de modèles de référence, en effectuant une corrélation entre d'une part la valeur estimée fournie par le troisième modèle d'apprentissage automatique pendant la phase opérationnelle et d'autre part des valeurs estimées fournies par la pluralité de modèles de référence après injection de données identiques à des données injectées dans le troisième modèle d'apprentissage automatique pendant la phase opérationnelle ; et
- réaliser (1102) un nouvel apprentissage du troisième modèle d'apprentissage automatique, avec un nouveau jeu de données d'apprentissage préalablement généré avec le modèle le plus proche.

12. Produit programme d'ordinateur, comportant des instructions entraînant l'exécution, par un processeur, du procédé de désagrégation de charges selon l'une quelconque des revendications 1 à 11, lorsque lesdites instructions sont exécutées par le processeur.

13. Support de stockage (203), stockant un programme d'ordinateur comportant des instructions entraînant l'exécution, par un processeur, du procédé de désagrégation de charges selon l'une quelconque des revendications 1 à 11, lorsque lesdites instructions sont lues et exécutées par le processeur.

14. Système de désagrégation de charges, comportant une circuiterie électronique configurée pour implémenter le procédé de désagrégation de charges selon l'une quelconque des revendications 1 à 11.

15. Compteur d'électricité communicant (101), comprenant un système de désagrégation de charges selon la revendication 14.
